(19) 

Europäisches Patentamt

European Patent Office

Office européen des brevets

(11) **EP 4 567 545 A1**

(12) **EUROPEAN PATENT APPLICATION**

(43) Date of publication:
**11.06.2025 Bulletin 2025/24**

(51) International Patent Classification (IPC):
*G05F 3/22* *(2006.01)*

(21) Application number: **24179905.5**

(22) Date of filing: **04.06.2024**

(52) Cooperative Patent Classification (CPC):
**G05F 3/225**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.12.2023 KR 20230175555**

(71) Applicant: **Samsung Electronics Co., Ltd.**
**Suwon-si, Gyeonggi-do 16677 (KR)**

(72) Inventor: **HEO, Donghun**
**16677 Suwon-si (KR)**

(74) Representative: **Marks & Clerk LLP**
**15 Fetter Lane**
**London EC4A 1BW (GB)**

(54) **CURRENT GENERATOR, SEMICONDUCTOR DEVICE, AND RECEIVER**

(57) A current generator may include an amplifier configured to receive a reference voltage through a first input terminal, receive a feedback voltage through a second input terminal, and generate an output voltage based on a difference of the reference voltage and the feedback voltage, a first resistor a second resistor, a first transistor, a second transistor configured to transfer a first current through a first terminal, and a third transistor having a gate connected to an output terminal of the amplifier, a first terminal connected to a power source, and configured to transfer a second current that is a mirror current of a first current through a second terminal.

FIG. 2

EP 4 567 545 A1

**Description**

TECHNICAL FIELD

The present invention generally relates to a current generator. The disclosure further describes a semiconductor device comprising such a current generator.

BACKGROUND

The performance of semiconductor devices may be affected by changes in temperature, but may be compensated for by appropriate bias circuit design. In general, a bandgap reference (BGR) circuit and a proportional to absolute temperature (PTAT) circuit may be used to compensate for temperature changes. The BGR circuit supplies a constant current (or voltage) regardless of the manufacturing process or changes in ambient temperature, and the PTAT circuit may supply a current linearly proportional to the absolute temperature. The BGR circuit and PTAT circuit may cancel the temperature dependence and compensate for the output voltage of the transconductance-dependent block through temperature changes.

SUMMARY

According to an aspect, the present invention provides a current generator may include an amplifier configured to receive a reference voltage through a first input terminal, receive a feedback voltage through a second input terminal, and generate an output voltage based on a difference of the reference voltage and the feedback voltage, a first resistor having a first end connected to the second input terminal and a second end being grounded, a first resistor having one end connected to the second input terminal and the other end being grounded, a second resistor having a first end connected to a first node connected to the second input terminal, a first transistor having a first terminal connected to the second resistor and a second terminal and a control terminal being grounded, a second transistor having a gate connected to an output terminal of the amplifier, a first terminal connected to the first node, a second terminal connected to a power source, and configured to transfer a first current through the first terminal, and a third transistor having a gate connected to the output terminal of the amplifier, a first terminal connected to the power source, and configured to transfer a second current that is a mirror current of the first current through the second terminal.

According to another aspect, a semiconductor device may include a controller configured to generate a voltage control signal, a voltage generator configured to generate a reference voltage based on the voltage control signal, and a current generator configured to generate a first current having a constant magnitude in a first region where a temperature is lower the reference temperature, and generate a second current whose magnitude is proportional to the temperature in a second region where the temperature is greater than or equal to the reference temperature, based on a reference temperature determined by the reference voltage.

There is further disclosed a receiver that may include an equalizer configured to perform equalization to data received through a communication channel by using an amplifier, and a current generator configured to generate a bias current having a constant magnitude in a first region where a temperature is lower a reference temperature, generate the bias current whose magnitude is proportional to the temperature in a second region where the temperature is greater than or equal to the reference temperature, and transfer the bias current to the amplifier.

Preferred embodiments are defined by the dependent claims.

BRIEF DESCRIPTION OF THE DRAWINGS

Example implementations will be more clearly understood from the following detailed description, taken in conjunction with the accompanying drawings.

FIG. 1 is a block diagram of an example of a semiconductor device according to some implementations.
FIG. 2 is a circuit diagram of an example of a current generator according to some implementations.
FIGS. 3 and 4 are graphs showing temperature characteristics of an example of a transistor according to some implementations.
FIG. 5 is a drawing showing an operation of an example of a current generator according to some implementations.
FIG. 6 is a drawing showing an example of an operation of a current generator according to some implementations.
FIG. 7 is a graph showing currents generated by an example of a current generator according to some implementations.
FIG. 8 is a circuit diagram of an example of a current generator according to some implementations.
FIG. 9 is a block diagram of an examples of a semiconductor device according to some implementations.

FIG. 10 is a graph showing an operation of an example of a current generator based on the control of a controller according to some implementations.

FIG. 11 is a circuit diagram of an example of a current generator according to some implementations.

FIG. 12 is a circuit diagram of an example of a current generator according to some implementations.

FIG. 13 is a block diagram of an example of a semiconductor device according to some implementations.

FIG. 14 is a block diagram of an example of a memory device according to some implementations.

FIG. 15 is a block diagram of an example of a semiconductor system according to some implementations.

DETAILED DESCRIPTION

In general, the present disclosure is directed to a current generator, a semiconductor device, and a receiver capable of generating bias current based on changes in temperature.

Hereinafter, example implementations will be explained in detail with reference to the accompanying drawings.

Accordingly, the drawings and description are to be regarded as illustrative in nature and not restrictive. Like reference numerals designate like elements throughout the specification. In a flowchart described with reference to the drawings, an order of operations may be changed, several operations may be merged, some operations may be divided, and specific operations may not be performed.

In addition, expressions written in the singular may be construed in the singular or plural unless an explicit expression such as "one" or "single" is used. Terms including ordinal numbers such as first, second, and the like will be used only to describe various components, and are not to be interpreted as limiting these components. These terms may be used for the purpose of distinguishing one constituent element from other constituent elements.

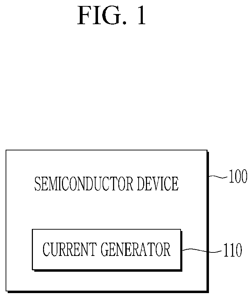

FIG. 1 is a block diagram of an example of a semiconductor device according to some implementations. In FIG. 1, a semiconductor device 100 may have different characteristics according to the change of temperature. For example, the semiconductor device 100 may include a transistor. In transistors, when the temperature rises, velocity saturation occurs in a region having a greater temperature than a particular temperature, which may reduce the transistor's transconductance. The decrease in the transconductance of the transistor may reduce the gain of the amplifier.

In order for the semiconductor device 100 to operate normally despite changes in temperature, a bias current with characteristics proportional to absolute temperature (PTAT) needs to be supplied. The bias current with PTAT characteristics may increase in magnitude as the temperature rises.

The semiconductor device 100 may include a current generator 110 generating the bias current. The current generator 110 may generate the bias current to determine an operating point for the semiconductor device 100 to operate stably. In some implementations, the semiconductor device 100 may include an amplifier, and the bias current may be used to compensate for the gain of the amplifier.

In some implementations, the current generator 110 may generate the bias current having a constant value in a range from a low temperature to a predetermined temperature, and may generate the bias current having the PTAT characteristics in a range from the predetermined temperature to a high temperature. In contrast, a different type of PTAT current generator generates a current whose magnitude varies over the entire temperature region, thereby having a wide range of current change. A common level of the output voltage of the amplifier that operates by receiving such current may significantly depend on the temperature. In addition, the performance of the amplifier may be lowered in low temperature regions because the current is small. However, embodiments of the current generator 110 may advantageously generate the bias current of a constant value in low temperature region, so there may be no degradation of characteristics in the low temperature region. Similarly advantageously, embodiments of the current generator 110 may generate the bias current having the PTAT characteristics in a high temperature region, and thereby the gain of the amplifier may be increased in embodiments.

The current generator 110 may transfer the bias current to a peripheral circuit, and the peripheral circuit may operate based on the bias current. Although the peripheral circuit may be disposed inside the semiconductor device 100, the present disclosure is not necessarily limited thereto, and the peripheral circuit may be disposed outside the semiconductor device 100.

The semiconductor device 100 may be included in an electronic device. For example, the electronic device may be implemented as one of various electronic devices such as desktop computers, laptop computers, tablet computers, smart phones, display devices, wearable devices, servers, video game consoles, home appliances and medical devices, but the embodiment is not limited thereto. The electronic device may be a component or intellectual property (IP) included in a single electronic device, and may be implemented as a circuit, a module, a chip, and/or a package-level entity.

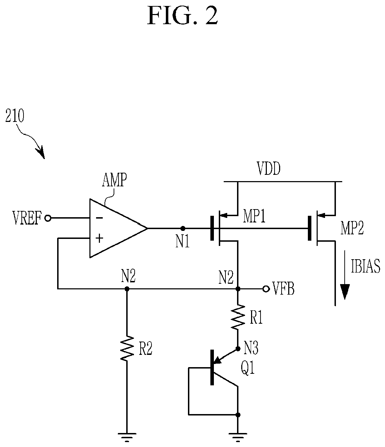

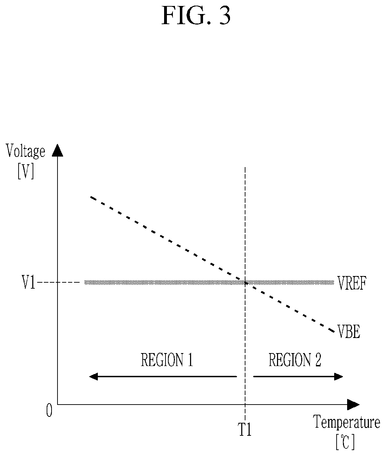

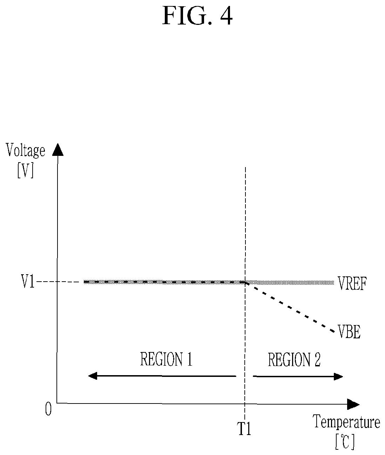

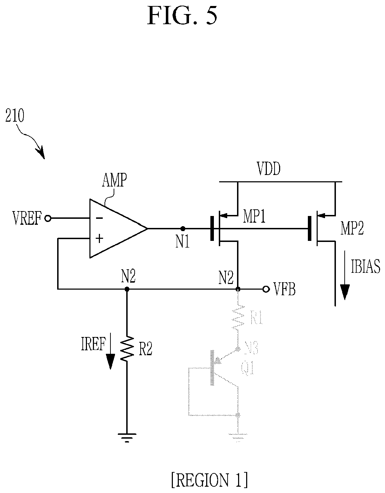

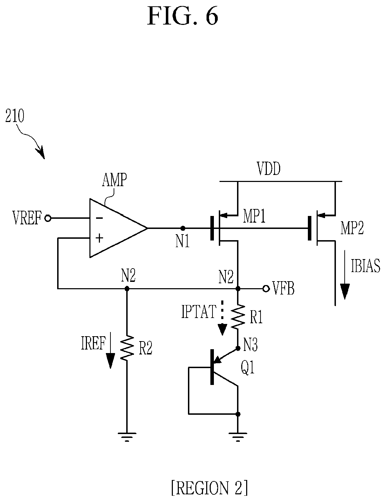

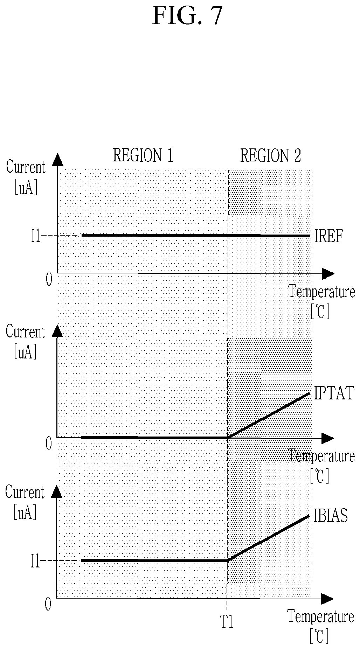

FIG. 2 is a circuit diagram of an example of a current generator according to some implementations. FIGS. 3 and 4 are graphs showing temperature characteristics of an example of a transistor according to some implementations. FIG. 5 is a drawing showing an operation of an example of a current generator according to some implementations. FIG. 6 is a drawing showing an operation of an example of a current generator according to some implementations. FIG. 7 is a graph showing currents generated by an example of a current generator according to some implementations.

In FIG. 2, a current generator 210 may receive a driving voltage VDD and a reference voltage VREF, and may generate a bias current IBIAS based on the driving voltage VDD and the reference voltage VREF. The current generator 210 may generate the bias current IBIAS based on a first temperature. For example, in a region where the temperature is lower than (or lower than or equal to) the first temperature, the current generator 210 may generate the bias current IBIAS having a constant magnitude. In a region where the temperature is higher than or equal to (or higher than) the first temperature, the current generator 210 may generate the bias current IBIAS whose magnitude is proportional to the temperature. That is, in a region where the temperature is higher than or equal to the first temperature, the current generator 210 may operate as a PTAT current generator. The first temperature may be determined by a value of the reference voltage VREF and temperature characteristics of a transistor Q1. The configuration for determining the first temperature will be described later with reference to FIG. 3.

The current generator 210 may include an amplifier AMP, a plurality of transistors MP1, MP2, and Q1, and a plurality of resistors R1 and R2. The amplifier AMP may receive the reference voltage VREF through an inverting input terminal ('-'). The reference voltage VREF may be generated by a power source inside or outside a semiconductor device (e.g., refer to 100 of FIG. 1). In some implementations, a bandgap reference (BGR) circuit may generate the reference voltage VREF.

The amplifier AMP may operate such that a voltage of a non-inverting input terminal ('+') may be equal to the reference voltage VREF. The non-inverting input terminal of the amplifier AMP may be connected to a node N2, and the node N2 may have a voltage VFB. The voltage VFB may be a feedback voltage corresponding to the reference voltage VREF. The voltage VFB may have a magnitude similar to or substantially the same as the reference voltage VREF.

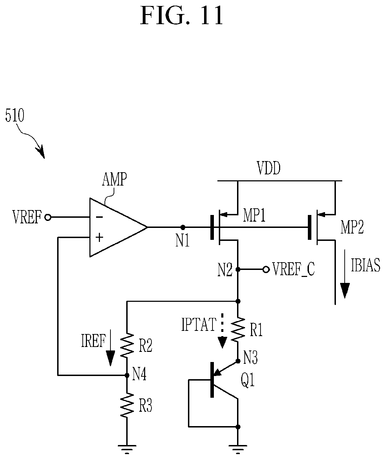

The non-inverting input terminal of the amplifier AMP may be connected to the resistors R1 and R2 and a transistor MP1 through the node N2. A first end of the resistor R2 may be connected to the node N2, and a second end of the resistor R2 may be grounded. A first end of the resistor R1 may be connected to the node N2, and a second end of the resistor R1 may be connected to the transistor Q1 at a node N3. The resistors R1 and R2 may be connected at the node N2 through electrical wiring. In some implementations, an additional resistor may be disposed between the resistors R1 and R2. The configuration where the additional resistor is disposed between the resistors R1 and R2 will be described later with reference to FIG. 11.

The transistor Q1 may be connected to the resistor R1 at the node N3. The transistor Q1 may be implemented as a bipolar junction transistor (BJT). In some implementations, the transistor Q1 may be a Positive-Negative-Positive (PNP) type transistor. The emitter of the transistor Q1 may be connected to the resistor R1 through the node N3. The base and the collector of the transistor Q1 may be grounded. That is, the voltage at the node N3 may correspond to a voltage difference between the emitter and the base (referred to as 'emitter-base voltage').

In some implementations, the transistor Q1 may be implemented as transistor operating in a sub-threshold value region. The sub-threshold value region may mean a region where the gate voltage is lower than (or lower than or equal to) the threshold voltage. The transistor operating in the sub-threshold value region may generate a current whose magnitude changes according to the change of temperature.

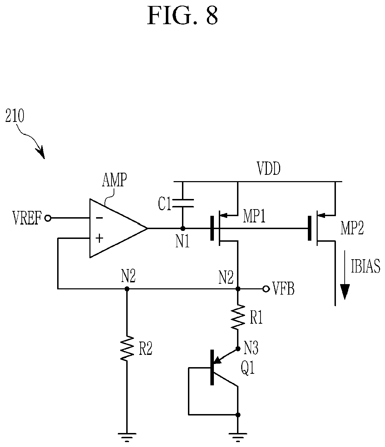

An output terminal of the amplifier AMP may be connected to transistors MP1 and MP2 through a node N1. The transistors MP1 and MP2 may operate based on an output voltage of the amplifier AMP. In some implementations, a compensation circuit may be disposed between the node N1 and the power source outputting the driving voltage VDD. The compensation circuit may include at least one of a capacitor and a resistor. The compensation circuit may be implemented as a serial and parallel combination of capacitors and resistors. The compensation circuit will be described later with reference to FIG. 8.

The transistors MP1 and MP2 may be implemented as a field effect transistor (FET). In an embodiment, the transistors MP1 and MP2 may be implemented as a metal oxide semiconductor (or Silicon) FET (MOSFET).

In some implementations, the transistors MP1 and MP2 may be implemented as a P-channel MOSFET (PMOS). The gates of the transistors MP1 and MP2 may be connected to the node N1, and may be turned ON and OFF based on the output of the amplifier AMP. The amplifier AMP may generate an output voltage based on a voltage difference between the inverting input terminal and the non-inverting input terminal. The transistors MP1 and MP2 may be connected to a power source through the source. The transistors MP1 and MP2 may receive the driving voltage VDD from the power source. The drain of the transistor MP1 may be connected to the node N2. A transistor MP2 may output the bias current IBIAS through the drain.

The current generator 210 may generate the bias current IBIAS based on temperature characteristics of the transistor Q1. Temperature characteristics of the transistor Q1 according to an embodiment are as shown in FIG. 3. FIG. 3 shows the temperature characteristics of the transistor Q1 itself, instead of showing temperature characteristics in the case that the transistor Q1 is disposed in the current generator 210.

In FIGS. 2 and 3, an emitter-collector voltage VBE of the transistor Q1 may have characteristics that linearly changes according to the temperature. For example, as the temperature increases, an emitter-base voltage VBE may decrease.

In FIG. 3, a magnitude of the reference voltage VREF may be V1 bolt [V]. The temperature of a point where the reference voltage VREF and the emitter-base voltage VBE intersect each other may be the first temperature T1 [°C]. That is, a value of the first temperature T1 may be changed by changing the magnitude of the reference voltage VREF. In an embodiment, a semiconductor device (e.g., refer to 100 of FIG. 1) or an external device may control the reference voltage VREF. In some implementations, the unit of the first temperature T1 may be expressed by using Kelvin [K]. A region whose temperature is lower than the first temperature T1 may be referred to as a first region REGION1, and a region whose temperature is higher than or equal to the first temperature T1 may be referred to as a second region REGION2.

In the first region, the emitter-base voltage VBE may be higher than the reference voltage VREF. When the transistor Q1 having such temperature characteristics is connected to the node N3, the direction of the current (e.g., downward direction) flowing through the resistor R1 and the transistor Q1 is fixed due to the transistor Q1, and the voltage of the node N3 may not be greater than the voltage VFB of the node N2. That is, the voltage of the node N3 may be smaller than or equal to the voltage VFB of the node N2.

As such, the temperature characteristics in the case that the transistor Q1 is disposed in the current generator 210 are as shown in FIG. 4. In FIGS. 2 and 4, in the first region, the emitter-base voltage VBE, which is the voltage of the node N3, and the voltage VFB of the node N2 may be the same as the reference voltage VREF.

In the first region, the current generator 210 may operate as shown in FIG. 5. In FIG. 5, current may not flow through the resistor R1 and the transistor Q1. A current IREF may flow through the resistor R2 based on the voltage VFB of the node N2. The current IREF may be expressed as Equation 1.

(Equation 1)

$$IREF = \frac{VREF}{R2}$$

Here, IREF represents a value of the current IREF flowing through the resistor R2, VREF represents the value of the reference voltage VREF, and R2 represents the resistance value of the resistor R2. In some implementations, the current IREF may have complementary to absolute temperature (CTAT) characteristic.

The current IREF may also flow through the transistor MP1. For example, the current IREF may flow through the transistor MP1 based on a source-gate voltage. The source-gate voltage may represent a voltage difference between the driving voltage VDD and the node N1.

In the same way, the bias current IBIAS may flow through the transistor MP2 based on the source-gate voltage. Since the source-gate voltage of the transistor MP1 and the source-gate voltage of the transistor MP2 are the same, the magnitude of the bias current IBIAS may be equal to the current IREF. Since the reference voltage VREF is constant, the current IREF and the bias current IBIAS may also have a constant magnitude. That is, in the first region, the current generator 210 may generate the bias current IBIAS having a constant magnitude. The bias current IBIAS may be expressed as a copy current (or mirror current) of the current flowing through the transistor MP1 (e.g., the current IREF).

In FIGS. 2 to 4, an operation of the current generator 210 in the second region will be described. In the second region, the emitter-base voltage VBE may be lower than the reference voltage VREF. Accordingly, a voltage difference occurs between the node N2 and the node N3, and a current IPTAT flowing through the resistor R1 may be generated. The voltage VFB of the node N2 may be the reference voltage VREF, and the voltage of the node N3 may be the emitter-base voltage VBE. As the temperature increases based on the first temperature T1, the voltage difference increases and the magnitude of the current IPTAT may also increase. That is, in the second region, the current IPTAT may be a current whose magnitude increases in proportion to the temperature.

The current IPTAT flowing through the resistor R1 may be expressed as Equation 2.

(Equation 2)

$$IPTAT = \frac{(VREF - VBE)}{R1}$$

Here, IPTAT represents a value of the current IPTAT flowing through the resistor R1, VREF represents the value of the reference voltage VREF, VBE represents the value of the emitter-base voltage VBE, and R1 represents the resistance value of the resistor R1.

The current IREF may flow through the resistor R2, the current IPTAT may flow through the resistor R1, and a current corresponding to 'the current IREF+the current IPTAT' may flow through the transistor MP1.

In the same way, the bias current IBIAS corresponding to 'the current IREF+the current IPTAT' may flow through the transistor MP2. Since the reference voltage VREF is constant, the current IREF may have a constant magnitude. Since the magnitude of the current IPTAT increase in proportion to the temperature, the bias current IBIAS may also have the characteristic of increasing magnitude in proportion to the temperature. That is, in the second region, the current generator 210 may generate the bias current IBIAS whose magnitude increases in proportion to the temperature.

In the second region, the bias current IBIAS may be expressed as Equation 3.

(Equation 3)

$$IBIAS = IREF + IPTAT$$

$$= \frac{VREF}{R2} + \frac{(VREF - VBE)}{R1}$$

Here, IBIAS represents the value of the bias current IBIAS, and the contents of Equation 1 and Equation 2 are equally applied to the remaining terms.

The currents IREF, IPTAT, and IBIAS generated by the current generator 210 according to an embodiment may be as shown in FIG. 7. In FIG. 7, the current generator 210 may generate the current IREF having a constant magnitude of I1 [μA] in the first region. The current generator 210 may not generate the current IPTAT in the first region. That is, the current generator 210 may generate the bias current IBIAS having a constant magnitude of I1 [μA] in the first region.

The current generator 210 may generate the current IREF having a constant magnitude of I1 [μA] in the second region. That is, the current generator 210 may generate the current IREF of a constant magnitude even if the temperature changes. The current generator 210 may generate the current IPTAT whose magnitude increases in proportion to the temperature in the second region. Accordingly, the current generator 210 may generate the bias current IBIAS whose magnitude increases in proportion to the temperature in the second region. In some implementations, the bias current IBIAS generated in the second region by the current generator 210 may not necessarily increase linearly in proportion to the temperature.

FIG. 8 is a circuit diagram of an example of a current generator according to some implementations. In FIG. 8, a current generator 215 according to an embodiment may receive the driving voltage VDD and the reference voltage VREF, and may generate the bias current IBIAS based on the driving voltage VDD and the reference voltage VREF.

The current generator 215 may generate the bias current IBIAS based on the first temperature. For example, in a region where the temperature is lower than (or lower than or equal to) the first temperature, the current generator 215 may generate the bias current IBIAS having a constant magnitude. In a region where the temperature is higher than or equal to (or higher than) the first temperature, the current generator 215 may generate the bias current IBIAS whose magnitude is proportional to the temperature. That is, in a region where the temperature is higher than or equal to the first temperature, the current generator 215 may operate as a PTAT current generator. The first temperature may be determined by the value of the reference voltage VREF and the temperature characteristics of the transistor Q1. The configuration for determining the first temperature will be described later with reference to FIG. 3.

The current generator 215 may include the amplifier AMP, a capacitor C1, the plurality of transistors MP1, MP2, and Q1, and the plurality of resistors R1 and R2. The amplifier AMP, with respect to the plurality of transistors MP1, MP2, and Q1, and the plurality of resistors R1 and R2, the contents of FIG. 2 may be equally applied to. Accordingly, redundant description will be omitted.

The output terminal of the amplifier AMP may be connected to the capacitor C1 and the transistors MP1 and MP2 through the node N1. The first end of the capacitor C1 may be connected to the power source, and the second end of the capacitor C1 may be connected to the node N1. The capacitor C1 may be charged based on the difference between the driving voltage VDD and the voltage of the node N1. The transistors MP1 and MP2 may operate based on the charged voltage of the capacitor C1.

In FIG. 8, the capacitor C1, as the compensation circuit, is disposed between the node N1 and the power source but the embodiment is not necessarily limited thereto, and the compensation circuit may be implemented to include at least one of a capacitor and a resistor. When the compensation circuit includes both a capacitor and a resistor, the compensation circuit may be implemented as a serial and/or parallel combination of the capacitor and the resistor.

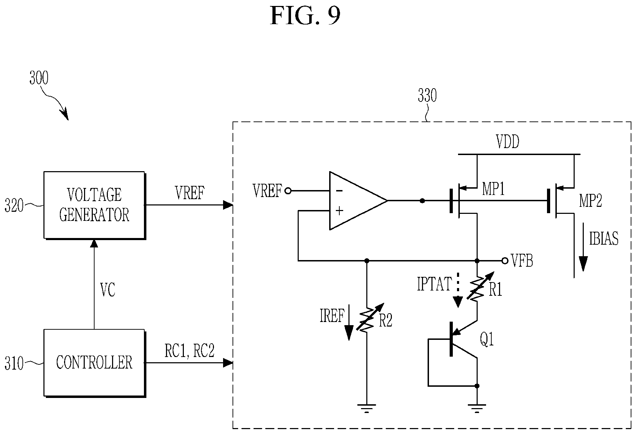

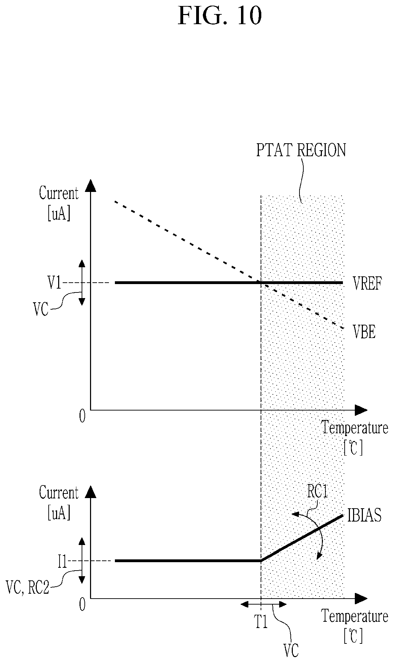

FIG. 9 is a block diagram of an example of a semiconductor device according to some implementations. FIG. 10 is a graph showing an operation of an example of a current generator based on the control of a controller according to some implementation.

In FIG. 9, a semiconductor device 300 may include a controller 310, a voltage generator 320, and a current generator 330. The content of the current generator 210 described with reference to FIG. 2 to FIG. 7 may be equally applied to the current generator 330. In some implementations, the controller 310, the voltage generator 320, and the current generator 330 may be integrated into one semiconductor chip, or may be individually implemented in a plurality of semiconductor chips.

The controller 310 may control an overall operation of the semiconductor device 300. In some implementations, the controller 310 may control at least one of the voltage generator 320 and the current generator 330. For example, the controller 310 may generate a control signal VC for controlling the voltage generator 320. The controller 310 may transmit the control signal VC to the voltage generator 320. The voltage generator 320 may generate the reference voltage VREF based on the control signal VC. The voltage generator 320 may transfer the reference voltage VREF to the current generator 330. In some implementations, the voltage generator 320 may generate the driving voltage VDD and transfer it to the current generator 330.

The controller 310 may generate control signals RC1 and RC2 for controlling the current generator 330. The control signals RC1 and RC2 may be a signal for adjusting the resistance values of the resistors R1 and R2 of the current generator 330. For example, the resistors R1 and R2 may be implemented as a variable resistor.

In FIGS. 9 and 10, the controller 310 may output the control signal VC to the voltage generator 320, and the voltage generator 320 may adjust the reference voltage VREF based on the control signal VC. For example, the voltage generator 320 may adjust the reference voltage VREF to be greater than or to be less than V1 based on the control signal VC.

Due to the adjustment of the reference voltage VREF, the point where the reference voltage VREF and the emitter-base voltage VBE of the transistor Q1 intersect may also be changed. That is, the first temperature T1 may also be changed due to the adjustment of the reference voltage VREF. For example, when the reference voltage VREF becomes greater than V1, the first temperature T1 may be reduced, and when the reference voltage VREF becomes smaller than V1, the first temperature T1 may be increased.

The adjustment of the reference voltage VREF may also affect the currents IREF and IBIAS. Since the current IREF is determined based on the reference voltage VREF as in Equation 2, the current IREF may be adjusted to be larger than or to be smaller than I1 by adjusting the reference voltage VREF.

The current IREF may be controlled based on the resistance value of the resistor R2. For example, the controller 310 may transfer a control signal RC2 to the resistor R2. The resistor R2 may increase or decrease the resistance based on the control signal RC2. When the resistance value of the resistor R2 decreases, the current IREF may become greater than I1, and when the resistance value of the resistor R2 increases, the current IREF may become smaller than I1. As shown in Equation 3, the bias current IBIAS may be adjusted by adjusting the current IREF.

The controller 310 may transfer a control signal RC1 to the resistor R1. The resistor R1 may increase or decrease the resistance based on the control signal RC1. Adjustment of the resistance of the resistor R1 may change the slope of the current IPTAT. When the resistance value of the resistor R1 decreases, the slope may increase, and when the resistance value of the resistor R1 increases, the slope may decrease. As shown in Equation 3, the slope of the bias current IBIAS in the PTAT region may be changed by adjusting the current IPTAT.

As such, in FIGS. 9 and 10, the controller 310 may control at least one of the reference voltage VREF and the currents IREF, IPTAT, and IBIAS. In some implementations, the current generator 330 may further include the compensation circuit. The compensation circuit described with reference to FIG. 8 may be equally applied.

FIG. 11 is a circuit diagram of an example of a current generator according to some implementations. In FIG. 11, a current generator 510 may receive the driving voltage VDD and the reference voltage VREF, and may generate the bias current IBIAS based on the driving voltage VDD and the reference voltage VREF.

The current generator 510 may generate the bias current IBIAS based on the first temperature. For example, in a region where the temperature is lower than (or lower than or equal to) the first temperature, the current generator 510 may generate the bias current IBIAS having a constant magnitude. In a region where the temperature is higher than or equal to (or higher than) the first temperature, the current generator 510 may generate the bias current IBIAS whose magnitude is proportional to the temperature. That is, in a region where the temperature is higher than or equal to the first temperature, the current generator 510 may operate as a PTAT current generator. The first temperature may be determined by the value of the reference voltage VREF and the temperature characteristics of the transistor Q1.

The current generator 510 may include the amplifier AMP, the plurality of transistors MP1, MP2, and Q1, and a plurality of resistors R1, R2, and R3.

The amplifier AMP may receive the reference voltage VREF through the inverting input terminal. The reference voltage VREF may be generated by a power source inside or outside a semiconductor device (e.g., refer to 100 of FIG. 1). In some implementations, a bandgap reference (BGR) circuit may generate the reference voltage VREF.

The amplifier AMP may operate such that the voltage of the non-inverting input terminal may be equal to the reference voltage VREF. The non-inverting input terminal of the amplifier AMP may be connected to a node N4. The output of the amplifier AMP may be fed back to the non-inverting input terminal through nodes N1, N2, and N4. Voltage of the node N4 may have a magnitude similar to or substantially the same as the reference voltage VREF.

The non-inverting input terminal of the amplifier AMP may be connected to resistors R2 and R3 through the node N4. The first end of the resistor R2 may be connected to the node N4, and the second end of the resistor R2 may be connected to the transistor MP1, and Q1 at the node N2. A first end of a resistor R3 may be connected to the node N4, and a second end of the resistor R3 may be grounded.

The first end of the resistor R1 may be connected to the node N2, and the second end of the resistor R1 may be connected to the transistor Q1 through the node N3. The transistor Q1 may be connected to the resistor R1 at the node N3. The transistor Q1 may be implemented as a bipolar junction transistor (BJT). In an embodiment, the transistor Q1 may be a PNP-type transistor. The emitter of the transistor Q1 may be connected to the resistor R1 through the node N3. The base and the collector of the transistor Q1 may be grounded. That is, the voltage at the node N3 may correspond to the emitter-base voltage. In some implementations, the transistor Q1 may be implemented as transistor operating in the sub-threshold value region. The sub-threshold value region may mean a region where the gate voltage is lower than (or lower than or equal to) the threshold voltage. The transistor operating in the sub-threshold value region may generate a current whose magnitude changes according to the change of temperature.

The output terminal of the amplifier AMP may be connected to the transistors MP1 and MP2 through the node N1. The transistors MP1 and MP2 may operate based on the output voltage of the amplifier AMP. In some implementation, the current generator 510 may further include the compensation circuit connected to the node N1. The compensation circuit described with reference to FIG. 8 may be equally applied.

The transistors MP1 and MP2 may be implemented as a field effect transistor (FET). In an embodiment, the transistors MP1 and MP2 may be implemented as a MOSFET.

In some implementations, the transistors MP1 and MP2 may be implemented as a PMOS. The gates of the transistors MP1 and MP2 may be connected to the node N1, and may be turned ON and OFF based on the output of the amplifier AMP. The amplifier AMP may generate the output voltage based on the voltage difference between the inverting input terminal and the non-inverting input terminal. The transistors MP1 and MP2 may be connected to a power source through the source. The transistors MP1 and MP2 may receive the driving voltage VDD from the power source. The drain of the transistor MP1 may be connected to the node N2. The transistor MP2 may output the bias current IBIAS through the drain.

The current generator 510 may operate in an environment where the reference voltage VREF is relatively low. For example, the reference voltage VREF of the current generator 510 may be lower than the reference voltage VREF used in the current generator 210 of FIG. 2.

A voltage VREF_C of the node N2 may be higher than the reference voltage VREF. The current IREF flowing through the resistor R2 may be expressed as Equation 4.

(Equation 4)

$$IREF = \frac{(VREF\_C - VREF)}{R2}$$

Here, IREF represents the value of the current IREF flowing through the resistor R2, VREF_C represents the value of the voltage VREF_C of the node N2, and VREF represents the value of the reference voltage VREF, and R2 represents the resistance value of the resistor R2. The current IREF may maintain a constant value even if the temperature changes.

The current flowing through the resistor R3 may be expressed as 'VREF/R3 ', and may be the same as the current IREF.

In a region where the temperature is higher than or equal to the first temperature, the current IPTAT may flow through the resistor R1 and the transistor Q1. The current IPTAT may be expressed as Equation 5.

(Equation 5)

$$IPTAT = \frac{(VREF\_C - VBE)}{R1}$$

Here, IPTAT represents the value of the current IPTAT flowing through the resistor R1, VREF_C represents the value of the voltage VREF _C of the node N2, and VBE represents the value of the emitter-base voltage VBE of the transistor Q1, and R1 represents the resistance value of the resistor R1.

The bias current IBIAS may be expressed as a sum of the current IREF and the current IPTAT. That is, in a region where the temperature is lower than the first temperature, the current generator 510 may generate the bias current IBIAS having a constant magnitude based on the current IREF. In a region where the temperature is higher than or equal to the first temperature, the current generator 510 may generate the bias current IBIAS whose magnitude is proportional to the temperature based on the current IREF and the current IPTAT.

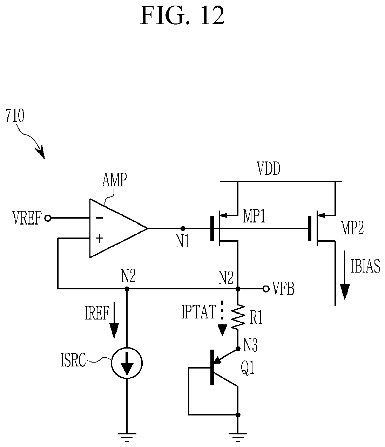

FIG. 12 is a circuit diagram of an example of a current generator according to some implementations. In FIG. 12, a current generator 710 may receive the driving voltage VDD and the reference voltage VREF, and may generate the bias current IBIAS based on the driving voltage VDD and the reference voltage VREF.

The current generator 710 may generate the bias current IBIAS based on the first temperature. For example, in a region where the temperature is lower than (or lower than or equal to) the first temperature, the current generator 710 may generate the bias current IBIAS having a constant magnitude. In a region where the temperature is higher than or equal to (or higher than) the first temperature, the current generator 710 may generate the bias current IBIAS whose magnitude is proportional to the temperature. That is, in a region where the temperature is higher than or equal to the first temperature, the current generator 710 may operate as a PTAT current generator. The first temperature may be determined by the value of the reference voltage VREF and the temperature characteristics of the transistor Q1.

The current generator 710 may include the amplifier AMP, the plurality of transistors MP1, MP2, and Q1, the resistor R1, and a current source ISRC.

The amplifier AMP may receive the reference voltage VREF through the inverting input terminal. The reference voltage VREF may be generated by a power source inside or outside a semiconductor device (e.g., refer to 100 of FIG. 1). In some implementations, a bandgap reference (BGR) circuit may generate the reference voltage VREF.

The amplifier AMP may operate such that the voltage of the non-inverting input terminal may be equal to the reference voltage VREF. The non-inverting input terminal of the amplifier AMP may be connected to the node N2, and the node N2 may have the voltage VFB. The voltage VFB may be a feedback voltage corresponding to the reference voltage VREF. The voltage VFB may have a magnitude similar to or substantially the same as the reference voltage VREF.

The non-inverting input terminal of the amplifier AMP may be connected to the current source ISRC, the resistor R1, and the transistor MP1 through the node N2. The current source ISRC may be configured to generate the current IREF. The current IREF may be a direct current (DC). A first end of the current source ISRC may be connected to the node N2, and a second end of the current source ISRC may be grounded. The first end of the resistor R1 may be connected to the node N2, and the second end of the resistor R1 may be connected to the transistor Q1 at the node N3.

The transistor Q1 may be connected to the resistor R1 at the node N3. The transistor Q1 may be implemented as a bipolar junction transistor (BJT). In some implementations, the transistor Q1 may be a PNP-type transistor. The emitter of the transistor Q1 may be connected to the resistor R1 through the node N3. The base and the collector of the transistor Q1 may be grounded. That is, the voltage at the node N3 may correspond to the emitter-base voltage. In some implementations, the transistor Q1 may be implemented as transistor operating in the sub-threshold value region.

The output terminal of the amplifier AMP may be connected to the transistors MP1 and MP2 through the node N1. The transistors MP1 and MP2 may operate based on the output voltage of the amplifier AMP. In some implementations, the current generator 710 may further include the compensation circuit connected to the node N1. The compensation circuit described with reference to FIG. 8 may be equally applied.

The transistors MP1 and MP2 may be implemented as a field effect transistor (FET). In an embodiment, the transistors MP1 and MP2 may be implemented as a MOSFET.

In some implementations, the transistors MP1 and MP2 may be implemented as a PMOS. The gates of the transistors MP1 and MP2 may be connected to the node N1, and may be turned ON and OFF based on the output of the amplifier AMP. The amplifier AMP may generate the output voltage based on the voltage difference between the inverting input terminal and the non-inverting input terminal. The transistors MP1 and MP2 may be connected to a power source through the source. The transistors MP1 and MP2 may receive the driving voltage VDD from the power source. The drain of the transistor MP1 may be connected to the node N2. The transistor MP2 may output the bias current IBIAS through the drain.

The current source ISRC may generate the constant the current IREF even if the temperature changes. In a region where the temperature is lower than the first temperature, the bias current IBIAS may also have a constant magnitude due to the current IREF of the current source ISRC.

In a region where the temperature is higher than or equal to the first temperature, the current IPTAT may flow through the resistor R1 and the transistor Q1. The current IPTAT may be expressed as Equation 2 described above.

The bias current IBIAS may be expressed as a sum of the current IREF and the current IPTAT. That is, in a region where the temperature is lower than the first temperature, the current generator 710 may generate the bias current IBIAS having a constant magnitude based on the current IREF. In a region where the temperature is higher than or equal to the first temperature, the current generator 710 may generate the bias current IBIAS whose magnitude is proportional to the temperature based on the current IREF and the current IPTAT.

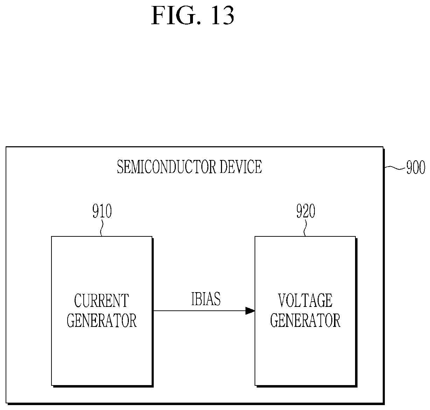

FIG. 13 is a block diagram of an example of a semiconductor device according to some implementations. In FIG. 13, a semiconductor device 900 according to an embodiment may include a current generator 910 and a voltage generator 920.

EP 4 567 545 A1

In a region where the temperature is lower than (or lower than or equal to) the first temperature, the current generator 910 according to an embodiment may generate the bias current IBIAS having a constant magnitude. In a region where the temperature is higher than or equal to (or higher than) the first temperature, the current generator 910 may generate the bias current IBIAS whose magnitude is proportional to the temperature. That is, the content of the current generator described with reference to FIG. 1 to FIG. 12 may be equally applied to the current generator 910. The current generator 910 may transfer the bias current IBIAS to the voltage generator 920.

The voltage generator 920 may generate voltage based on the bias current IBIAS. In an embodiment, the voltage generator 920 may include a resistor. The voltage generator 920 may generate a voltage by applying the bias current IBIAS to the resistor. The voltage generator 920 may transfer the generated voltage to a peripheral circuit. In an embodiment, the voltage generated by the voltage generator 920 may be used, as a reference voltage, for operation of the semiconductor device 900.

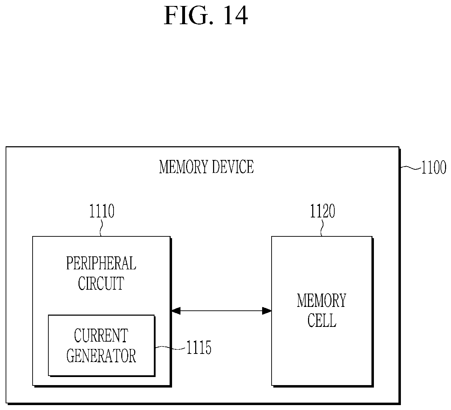

FIG. 14 is a block diagram of an example of a memory device according to some implementations. In FIG. 14, a memory device 1100 according to an embodiment may be configured to store data. The memory device 1100 may be implemented as a volatile memory or non-volatile memory.

As an example, the memory device 1100 may be a dynamic random-access memory (DRAM) or static RAM(SRAM). For example, DRAM may be double data rate synchronous dynamic random-access memory (DDR SDRAM), low-power DDR (LPDDR) SDRAM, graphics DDR (GDDR) SDRAM, Rambus DRAM (RDRAM), or the like.

As another example, the memory device 1100 may be NAND flash memory, vertical NAND (VNAND) flash memory, bonding vertical NAND (BVNAND) flash memory, NOR flash memory, resistive RAM (RRAM), phase-change RAM (PRAM), magnetoresistive RAM (MRAM), ferroelectrics RAM (FRAM), spin transfer torque RAM (STT-RAM), conductive bridging RAM (CBRAM), or the like.

The memory device 1100 may include a peripheral circuit 1110 and a memory cell 1120. The memory device 1100 may write data into the memory cell 1120, erase data from the memory cell 1120, or read data based on a command from a host. The peripheral circuit 1110 may generate voltage, current, signals, or the like, for the memory cell 1120 to perform memory operations (write, erase, read, or the like) in response to commands from the host. For example, the peripheral circuit 1110 may include a voltage generator, an address decoder, a pulse signal generator, a control logic, a buffer, or the like.

The memory device 1100 may include a current generator 1115. In a region where the temperature is lower than (or lower than or equal to) the first temperature, the current generator 1115 may generate bias current having a constant magnitude. In a region where the temperature is higher than or equal to (or higher than) the first temperature, the current generator 1115 may generate bias current whose magnitude is proportional to the temperature. That is, the content of the current generator described with reference to FIGS. 1 to 12 may be equally applied to the current generator 1115. The bias current generated by the current generator 1115 may be used by the peripheral circuit 1110 to generate voltage, current, signals, or the like. Depending on the embodiment, the current generator 1115 may be disposed outside the peripheral circuit 1110.

The memory cell 1120 may store data based on the voltage, current, signal, or the like of the peripheral circuit 1110. The memory cell 1120 may read data and transfer it to the peripheral circuit 1110.

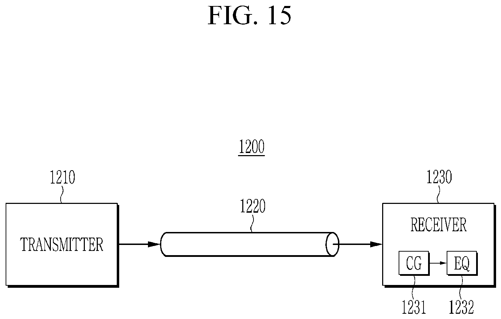

FIG. 15 is a block diagram of an example of a semiconductor system according to some implementations. In FIG. 15, an electronic system 1200 according to an embodiment may be a system that supports a high-speed interface (HSI).

The electronic system 1200 may include a transmitter 1210 and a receiver 1230. The transmitter 1210 and the receiver 1230 may each be implemented as being included in different electronic devices, or may be implemented as being included in one electronic device.

The electronic system 1200 may be provided with a communication channel 1220 between the transmitter 1210 and the receiver 1230. The transmitter 1210 may transmit data to the receiver 1230 through the communication channel 1220.

In an ideal case, data from the transmitter 1210 to the receiver 1230 should be transmitted lossless, but in reality, this is not the case. Due to the transfer function due to the relatively long length of the communication channel 1220, the material properties of the communication channel 1220, or the like, the digital pulse signal with a clear outline from the transmitter 1210 may be dispersed or spread out in a Gaussian shape at the time of arriving at the receiver 1230. Accordingly, the receiver 1230 may restore and use the data that has passed through the communication channel 1220.

In some implementations, the transmitter 1210 may be a host, and the receiver 1230 may be a memory device. The host may include a central processing unit (CPU), a graphics processing unit (GPU), an application processor (AP), or the like. The memory device may include a volatile memory or non-volatile memory, or the like.

In some implementations, the transmitter 1210 may be a host, and the receiver 1230 may be a peripheral device. The peripheral device may include a display device, a communication device, a storage device, a image sensor device, or the like.

In some implementations, the communication channel 1220 may be implemented as a wired channel for wired communication, such as copper wires, on a printed circuit board (PCB), or may be implemented as a wireless channel for wireless communication.

The receiver 1230 may include a current generator (CG) 1231 and an equalizer (EQ) 1232, in order to compensate for signal attenuation of data received through the communication channel 1220.

In a region where the temperature is lower than (or lower than or equal to) the first temperature, the current generator 1231 may generate a bias current having a constant magnitude. In a region where the temperature is higher than or equal to (or higher than) the first temperature, the current generator 1231 may generate the bias current whose magnitude is proportional to the temperature. That is, the content of the current generator described with reference to FIG. 1 to FIG. 12 may be equally applied to the current generator 1231. The current generator 1231 may transfer the bias current to the equalizer 1232.

The equalizer 1232 may equalize data to compensate for signal attenuation. The equalizer 1232 may include an amplifier. The transconductance of the amplifier may be degraded at high temperatures, and the bias current may be used to determine the operating point for the amplifier to operate stably.

In some implementations, the equalizer 1232 may include a passive equalizer, a continuous-time linear equalizer (CTLE)), a decision feedback equalizer (DFE), or the like. The passive equalizer may include serial and parallel combinations of resistors and capacitors, and perform boosting of data in the frequency domain. The current generator 1231 may boost the gain of the amplifier by supplying the bias current to CTLE, DFE, or the like.

In some implementations, the receiver 1230 may further include a variable gain amplifier (VGA), a clock data recovery (CDR) circuit, and a deserializer.

Embodiments are set out in the following clauses:

Clause 1. A current generator, comprising:

an amplifier configured to receive a reference voltage through a first input terminal, receive a feedback voltage through a second input terminal, and generate an output voltage based on a difference of the reference voltage and the feedback voltage;
a first resistor having a first end connected to the second input terminal and a second end connected to ground;
a second resistor having a first end connected to a first node connected to the second input terminal;
a first transistor having a first terminal connected to the second resistor and a second terminal and a control terminal connected to ground;
a second transistor having a gate connected to an output terminal of the amplifier, a first terminal connected to the first node, a second terminal connected to a power source, and configured to transfer a first current through the first terminal; and
a third transistor having a gate connected to the output terminal of the amplifier, a first terminal connected to the power source, and configured to transfer a second current that is a mirror current of the first current through the second terminal.

Clause 2. The current generator of clause 1, further comprising a capacitor having a first end connected to the power source and a second end connected to the output terminal of the amplifier.

Clause 3. The current generator of any preceding clause,

wherein the first transistor is a Positive-Negative-Positive (PNP)-type bipolar junction transistor (BJT), and wherein the first terminal of the first transistor is an emitter, the second terminal is a collector, and the control terminal is a base.

Clause 4. The current generator of any preceding clause,

wherein the second transistor is a P-channel metal-oxide semiconductor field-effect transistor (MOSFET), and wherein the first terminal of the second transistor is a drain, the second terminal is a source, and the control terminal is a gate.

Clause 5. The current generator of any preceding clause,

wherein the third transistor is a P-channel MOSFET, and
wherein the first terminal of the third transistor is a drain, the second terminal is a source, and the control terminal is a gate.

Clause 6. The current generator of any preceding clause, further comprising a capacitor having a first end connected to the power source and a second end connected to the output terminal of the amplifier,
wherein the second transistor is configured to generate the first current based on a charged charge of the capacitor.

Clause 7. The current generator of any preceding clause, wherein the first resistor and the second resistor are variable resistors.

Clause 8. The current generator of any preceding clause, further comprising a third resistor having a first end connected to the first node and a second end connected to the second input terminal.

Clause 9. A semiconductor device, comprising:

a controller configured to generate a voltage control signal;
a voltage generator configured to generate a reference voltage based on the voltage control signal; and
a current generator configured to generate a first current having a constant magnitude in a first region where a first temperature is lower than a reference temperature, and generate a second current whose magnitude is proportional to a second temperature in a second region where the second temperature is greater than or equal to the reference temperature,
wherein the reference temperature is based on the reference voltage.

Clause 10. The semiconductor device of clause 9,

wherein the current generator comprises a bipolar junction transistor (BJT), and
wherein the reference temperature comprises a temperature of the BJT when an emitter-base voltage intersects the reference voltage.

Clause 11. The semiconductor device of clause 10, wherein the current generator is configured to generate the second current based on a difference between the reference voltage and the emitter-base voltage.

Clause 12. The semiconductor device of any one of clauses 9 to 11, wherein, in the second region, the current generator is configured to generate the first current having a constant magnitude and a third current whose magnitude is proportional to the second temperature, and generate a sum of the first current and the third current as the second current.

Clause 13. The semiconductor device of clause 12,

wherein the current generator comprises a first variable resistor for controlling the first current and a second variable resistor for controlling the third current, and
wherein the controller is configured to generate at least one of a first resistor control signal for controlling a resistance of the first variable resistor and a second resistor control signal for controlling a resistance of the second variable resistor.

Clause 14. The semiconductor device of any one of clauses 9 to 13,

wherein the current generator comprises a current source configured to generate the first current in the first region and the second region, and
wherein the second current comprises the first current.

Clause 15. The semiconductor device of any one of clauses 9 to 14, wherein the current generator comprises:

an amplifier configured to receive the reference voltage through a first input terminal and receive a feedback voltage of the reference voltage through a second input terminal; and
a first transistor having a gate connected to an output terminal of the amplifier, the first transistor configured to flow the first current in the first region and flow the second current in the second region.

Clause 16. The semiconductor device of clause 15, wherein the current generator further comprises a second transistor having a gate connected to the output terminal of the amplifier, the second transistor configured to generate mirror current of the first current and the second current.

Clause 17. A receiver, comprising:

an equalizer configured to perform equalization to data received through a communication channel by using an amplifier; and

a current generator configured to generate a bias current having a constant magnitude in a first region where a first temperature is lower a reference temperature, generate the bias current whose magnitude is proportional to the first temperature in a second region, where the first temperature is greater than or equal to the reference temperature, and transfer the bias current to the amplifier.

Clause 18. The receiver of clause 17,

wherein the current generator comprises a bipolar junction transistor (BJT), and
wherein the current generator is configured to generate the bias current based on temperature characteristics of the bipolar junction transistor.

Clause 19. The receiver of clause 17 or 18,

wherein the equalizer comprises a continuous-time linear equalizer (CTLE), and
wherein the current generator is configured to transfer the bias current to the continuous-time linear equalizer.

Clause 20. The receiver of clause 19, wherein the equalizer further comprises a passive equalizer comprising a combination of a resistor and a capacitor and configured to perform boosting of the data in a frequency domain.

In some implementations, each component or combinations of two or more components described with reference to FIGS. 1 to 15 may be implemented as a digital circuit, a programmable or non-programmable logic device or array, an application specific integrated circuit (ASIC), or the like. While this disclosure contains many specific implementation details, these should not be construed as limitations on the scope of what may be claimed: the invention is defined by the claims. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

**Claims**

1.   A current generator, comprising:

an amplifier configured to receive a reference voltage through a first input terminal, receive a feedback voltage through a second input terminal, and generate an output voltage based on a difference of the reference voltage and the feedback voltage;
a first resistor having a first end connected to the second input terminal and a second end connected to ground;
a second resistor having a first end connected to a first node connected to the second input terminal;
a first transistor having a first terminal connected to the second resistor and a second terminal and a control terminal connected to ground;
a second transistor having a control terminal connected to an output terminal of the amplifier, a first terminal connected to the first node, a second terminal connected to a power source, and configured to transfer a first current through the first terminal; and
a third transistor having a control terminal connected to the output terminal of the amplifier, a first terminal connected to the power source, and configured to transfer a second current that is a mirror current of the first current through a second terminal.

2.   The current generator of claim 1, further comprising a capacitor having a first end connected to the power source and a second end connected to the output terminal of the amplifier.

3.   The current generator of claim 1 or 2,

wherein the first transistor is a Positive-Negative-Positive (PNP)-type bipolar junction transistor, BJT, and wherein the first terminal of the first transistor is an emitter, the second terminal of the first transistor is a collector, and the control terminal of the first transistor is a base.

4. The current generator of any preceding claim,

wherein the second transistor is a P-channel metal-oxide semiconductor field-effect transistor, MOSFET, and wherein the first terminal of the second transistor is a drain, the second terminal of the second transistor is a source, and the control terminal is a gate.

5. The current generator of any preceding claim,

wherein the third transistor is a P-channel MOSFET, and wherein the first terminal of the third transistor is a drain, the second terminal is a source, and the control terminal is a gate.

6. The current generator of any preceding claim, further comprising a capacitor having a first end connected to the power source and a second end connected to the output terminal of the amplifier, wherein the second transistor is configured to generate the first current based on a charge stored in the capacitor.

7. The current generator of any preceding claim, wherein the first resistor and the second resistor are variable resistors.

8. The current generator of any preceding claim, further comprising a third resistor having a first end connected to the first node and a second end connected to the second input terminal.

9. A semiconductor device, comprising:

a controller configured to generate a voltage control signal;
a voltage generator configured to generate a reference voltage based on the voltage control signal; and
a current generator according to any preceding claim, the current generator preferably configured to generate a first current having a constant magnitude in a first temperature region where a temperature is lower than a reference temperature, and generate in a second temperature region where the temperature is greater than or equal to the reference temperature a second current whose magnitude is proportional to temperature, wherein the reference temperature is based on the reference voltage.

10. The semiconductor device of claim 9,

wherein the current generator comprises a bipolar junction transistor, BJT, and wherein the reference temperature comprises a temperature of the BJT when an emitter-base voltage intersects the reference voltage.

11. The semiconductor device of claim 10, wherein the current generator is configured to generate the second current based on a difference between the reference voltage and the emitter-base voltage.

12. The semiconductor device of any one of claims 9 to 11, wherein, in the second region, the current generator is configured to generate the first current having a constant magnitude and a third current whose magnitude is proportional to temperature, and generate a sum of the first current and the third current as the second current.

13. The semiconductor device of claim 12,

wherein the current generator comprises a first variable resistor to control the first current and a second variable resistor to control the third current, and wherein the controller is configured to generate at least one of a first resistor control signal to control a resistance of the first variable resistor and a second resistor control signal to control a resistance of the second variable resistor.

14. The semiconductor device of any one of claims 9 to 13,

wherein the current generator comprises a current source configured to generate the first current in the first region and the second region, and

wherein the second current comprises the first current.

15. The semiconductor device of any one of claims 9 to 14, wherein the current generator comprises:

an amplifier having a first input terminal and a second input terminal and configured to receive the reference voltage through the first input terminal and receive a feedback voltage of the reference voltage through the second input terminal; and

a first transistor having a control terminal connected to an output terminal of the amplifier, the first transistor configured to generate the first current in the first region and generate the second current in the second region.

FIG. 1

```
+-----------------------------------+
|                                   |——100
|   SEMICONDUCTOR DEVICE            |
|                                   |
|   +---------------------------+   |
|   |   CURRENT GENERATOR       |——110
|   +---------------------------+   |
|                                   |
+-----------------------------------+
```

# FIG. 2

# FIG. 3

# FIG. 4

# FIG. 5

[REGION 1]

# FIG. 6

210

AMP

VREF

VDD

MP1

N1

MP2

IBIAS

N2

N2

VFB

IPTAT

R1

IREF

R2

N3

Q1

[REGION 2]

# FIG. 7

# FIG. 8

# FIG. 9

EP 4 567 545 A1

# FIG. 10

PTAT REGION

Current
[uA]

V1
VC

VREF

VBE

0
Temperature
[℃]

Current
[uA]

RC1

IBIAS

I1

VC, RC2

0
T1
VC
Temperature
[℃]

# FIG. 11

510

# FIG. 12

# FIG. 13

SEMICONDUCTOR DEVICE ~900

910

920

CURRENT GENERATOR

IBIAS →

VOLTAGE GENERATOR

# FIG. 14

MEMORY DEVICE · ~1100

1110

PERIPHERAL CIRCUIT

CURRENT GENERATOR — 1115

1120

MEMORY CELL

# FIG. 15

Europäisches
Patentamt

European
Patent Office

Office européen
des brevets

# EUROPEAN SEARCH REPORT

**Application Number**

EP 24 17 9905

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2006 059315 A (ASAHI CHEMICAL MICRO SYST) 2 March 2006 (2006-03-02) | 1,3-5, 9-12,14, 15 | INV. G05F3/22 |
| Y | * abstract; figure 2 * | 2,6-8,13 | |
| Y | BANBA H ET AL: "A CMOS BANDGAP REFERENCE CIRCUIT WITH SUB-1-V OPERATION", IEEE JOURNAL OF SOLID-STATE CIRCUITS, IEEE, USA, vol. 34, no. 5, 1 May 1999 (1999-05-01), pages 670-673, XP000908580, ISSN: 0018-9200, DOI: 10.1109/4.760378 * abstract; figure 5 * | 2,6 | |
| Y | US 6 501 256 B1 (INTEL CORP [US]) 31 December 2002 (2002-12-31) * figure 4 * | 7,13 | |
| Y | US 2007/076483 A1 (COLMAN DEREK [GB]) 5 April 2007 (2007-04-05) * abstract; figure 4 * | 8 | **TECHNICAL FIELDS SEARCHED (IPC)** |
| X | CN 112 034 922 A (CHENGDU IRIDIUM COMMUNICATIONS CO LTD) 4 December 2020 (2020-12-04) | 1-6, 9-12,14, 15 | G05F |
| Y | * abstract; figures 2,4 * | 7,8,13 | |

The present search report has been drawn up for all claims

| Place of search | Date of completion of the search | Examiner |
|---|---|---|
| The Hague | 15 November 2024 | Arias Pérez, Jagoba |

EPO FORM 1503 03.82 (P04C01)

## ANNEX TO THE EUROPEAN SEARCH REPORT
## ON EUROPEAN PATENT APPLICATION NO.

EP 24 17 9905

This annex lists the patent family members relating to the patent documents cited in the above-mentioned European search report.
The members are as contained in the European Patent Office EDP file on
The European Patent Office is in no way liable for these particulars which are merely given for the purpose of information.

15-11-2024

| Patent document cited in search report | | Publication date | Patent family member(s) | | Publication date |
|---|---|---|---|---|---|
| JP 2006059315 | A | 02-03-2006 | JP | 4722502 B2 | 13-07-2011 |
| | | | JP | 2006059315 A | 02-03-2006 |
| | | | US | 2006038608 A1 | 23-02-2006 |
| US 6501256 | B1 | 31-12-2002 | NONE | | |
| US 2007076483 | A1 | 05-04-2007 | GB | 2430766 A | 04-04-2007 |
| | | | US | 2007076483 A1 | 05-04-2007 |
| CN 112034922 | A | 04-12-2020 | NONE | | |

EPO FORM P0459

For more details about this annex : see Official Journal of the European Patent Office, No. 12/82